Europäisches Patentamt

European Patent Office

Office européen des brevets

(19)

(11) EP 0 619 279 B1

(12) **EUROPÄISCHE PATENTSCHRIFT**

(45) Veröffentlichungstag und Bekanntmachung des Hinweises auf die Patenterteilung:
**05.11.1997 Patentblatt 1997/45**

(51) Int. Cl.$^6$: **C04B 35/49**

(21) Anmeldenummer: 94103270.8

(22) Anmeldetag: **04.03.1994**

(54) **Piezokeramischer Werkstoff mit grosser piezoelektrischer Aktivität und hoher Dielektrizitätszahl**

Piezo-ceramic material having high piezo-electric activity and dielectric constant

Matériau piézocéramique à activité piézoélectrique élevée et à constante diélectrique élevée

(84) Benannte Vertragsstaaten:
**DE FR GB**

(30) Priorität: **12.03.1993 DE 4307804**

(43) Veröffentlichungstag der Anmeldung:
**12.10.1994 Patentblatt 1994/41**

(73) Patentinhaber:
**CeramTec AG Innovative Ceramic Engineering
73207 Plochingen (DE)**

(72) Erfinder:
• **Helke, Günter, Dr.
D-91207 Lauf (DE)**

• **Langer, Hans-Joachim
D-91207 Lauf (DE)**

(56) Entgegenhaltungen:
**EP-A- 0 374 378     DE-C- 1 646 675
FR-A- 1 554 730     FR-A- 2 569 398
GB-A- 1 312 140     GB-A- 2 068 355
US-A- 4 313 839**

• **JAPANESE JOURNAL OF APPLIED PHYSICS, Bd.6, Nr.8, August 1967, TOKYO JP Seiten 954 - 962 H. BANNO ET AL**

## Beschreibung

Die vorliegende Erfindung betrifft ein piezoelektrisches Keramikmaterial auf Basis von Bleititanatzirkonat mit weiteren Additiven, das sich durch eine hohe Dielektrizitätszahl in Kombination mit einem hohen elektromechanischen Kopplungsfaktor auszeichnet.

Die Modifizierung von Zusammensetzungen auf Basis der als Bleititanatzirkonat $Pb (Ti, Zr)O_3$ bekannten festen Lösungen von Bleititanat $PbTiO_3$ und Bleizirkonat $PbZrO_3$ durch Zusätze und/oder Substitute im Hinblick auf anwendungsgerechte Spezifikationen von piezokeramischen Werkstoffen ist schon bekannt. Insbesondere sind die Variationen der Eigenschaften mit dem stöchiometrischen Verhältnis Ti/Zr im $Pb (Ti, Zr)O_3$, der Einfluß der teilweisen Substitution von Erdalkalimetallen Ca und Sr anstelle von Pb, die signifikante Wirkung beispielsweise von Zusätzen drei- und fünfwertiger Ionen (Bi, La; Sb, Nb, Ta) als Dotanten und die Bildung von festen Lösungen des Bleititanatzirkonats mit komplexen Verbindungen, die ebenso wie das Bleititanatzirkonat die Kristallstruktur des Perowskits mit der Formel $[A^{2+}B^{4+}]O_3^{2-}$ besitzen, beschrieben.

Durch die Zusätze von drei- und fünfwertigen Ionen konnten Piezokeramiken hergestellt werden, die sich durch eine erhöhte Dielektrizitätszahl, hohe piezoelektrische Aktivität und größere dielektrische und mechanische Verluste sowie eine geringe Koerzitivkraft auszeichnen. Eine niedrige Koerzitivkraft kommt in dem Verhalten der Piezokeramik bei der Polung im elektrischen Gleichfeld zum Ausdruck; eine hohe remanente Polarisation als notwendige Voraussetzung für die piezoelektrische Aktivität der Keramik wird bei niedrigen Feldstärken erzielt.

Keramiken mit niedriger Koerzitivkraft, aber gleichzeitig hoher remanenter Polarisation werden in der Fachsprache auch als "weiche" Piezokeramiken klassifiziert.

Die allgemeine Formel beliebig modifizierter Zusammensetzung auf der Basis von $Pb (Ti, Zr)O_3$ ist dann

$$(A_1, A_2 ... A_n) (B_1, B_2 ... B_n)O_3.$$

Stöchiometrie und Ladungsneutralität werden durch die Einhaltung von Existenzbedingungen für komplexe Verbindungen, wie

$$(A_{1/2}^{1+} A_{1/2}^{3+}) TiO_3, \ Pb(B_{1/3}^{2+} B_{2/3}^{5+})O_3, \ Pb(B_{1/2}^{3+} B_{1/2}^{5+})O_3 \ Pb(B_{1/2}^{2+} B_{2/3}^{5+})O_3, \ Pb(B_{2/3}^{3+} B_{1/3}^{6+})O_3, \ Pb(B_{1/4}^{1+} B_{3/4}^{5+})O_3$$

gewährleistet.

Bei der Vielzahl von möglichen Modifikationen des $Pb(Ti, Zr)O_3$ durch die aufgeführten komplexen Verbindungen ist es gelungen, sehr leistungsfähige piezokeramische Werkstoffe unterschiedlicher Spezifikation herzustellen.

Eine seit längerem bekannte Vorgehensweise zur Herstellung "weicher" Keramiken mit hoher Dielektrizitätszahl und großer piezoelektrischer Aktivität ist der Zusatz von $WO_3$ zu $Pb(Ti, Zr)O_3$: Der Effekt des $WO_3$-Zusatzes entspricht dem von $La_2O_3$ oder $Nb_2O_5$. Die DE-A-16 46 675 beschreibt beispielsweise die Wirkung des Zusatzes $Pb(Mg_{1/3}Nb_{2/3})O_3 + NiO$ zu $Pb(Ti, Zr)O_3$, während die Wirkung des Zusatzes von $WO_3$ zu $Pb(Ti, Zr)O_3$ in Jap. J. Appl. Phys. 61 (1967) 8.954-961 hervorgehoben ist.

Vergleichbare Ergebnisse werden auch mit quaternären Zusammensetzungen, wie $Pb(Ti, Zr)O_3$ - $Pb(Zn_{1/3}Nb_{2/3})O_3$ - $Pb(Mg_{1/2}W_{1/2})O_3$ erreicht (Neorg. Mater. 26 (1990) 219 - 220).

US-A-4,313,839 lehrt piezokeramische Materialien, bei denen $Pb(W_{1/2} Ni_{1/2})O_3$ eine quaternäre Komponente ist. FR-A-1.554.730 beschreibt piezokeramische Materialien mit $Pb(W_{1/2} Ni_{1/2})O_3$ als einem von mehreren Additiven, wobei Pb durch Ba, Ca und Sr zu bis zu 20 % ersetzt sein kann.

Die bisher üblichen Zusätze bzw. Substituenten zur Modifikation von $Pb(Ti, Zr)O_3$ ergaben beispielsweise Piezokeramiken mit folgenden Eigenschaften:

Zusammensetzung (1):

$$0,97 \ Pb(Zr_{0,51}Ti_{0,49})O_3 - 0,03 \ WO_3$$

[a]

$$\frac{\varepsilon_{33}^T}{\varepsilon_0} = 1730$$

[b] $k_p = 0,55$

Zusammensetzung (2):
(gemäß J. Amer. Ceram. Soc. 49 (1966) 11, S. 577 - 582)

$$Pb(Mg_{1/3}Nb_{2/3})_{0,375}(Ti_{0,375}Zr_{0,25})O_3 + 1,0 \text{ Gew.-\% NiO}$$

[a]

$$\frac{\varepsilon^{T}_{33}}{\varepsilon_0} = 1930$$

[b] $k_p = 0,62$
[c] $T_S$; $t_s$: 1240 °C; 0,75 h

Zusammensetzung (3):

$$(Pb_{0,95}Sr_{0,05})(Mg_{1/3}Nb_{2/3})_{0,375}(Ti_{0,38}Zr_{0,245})O_3$$

[a]

$$\frac{\varepsilon^{T}_{33}}{\varepsilon_0} = 3856$$

[b] $k_p = 0,578$
[c] $T_S$; $t_s$: 1270 ... 1290 °C; 0,75 h

Mit

[a] Dielektrizitätszahl gem. DIN IEC 483
[b] elektromechanischer Kopplungsfaktor $k_p$ gem. DIN IEC 483
und
[c] Sintertemperatur $T_S$ und Sinterzeit $t_s$

Bei den vorstehend dargestellten bekannten Zusammensetzungen stellen sich Probleme der Optimierung wie folgt dar: Die Modifikation von $Pb(Ti, Zr)O_3$ durch Zusatz des einfachen Oxides $WO_3$ als Weichmacher ergibt eine Dielektrizitätszahl < 2000 bei relativ niedrigem elektromechanischem Kopplungsfaktor $k_p \leq 0,55$, vergleiche Zusammensetzung (1).

Eine Modifikation von $Pb(Ti, Zr)O_3$ in weiteren Grenzen bietet die Substitution von komplexen Verbindungen, was aus den Zusammensetzungen (2) und (3) ersichtlich wird. Hierbei zeigt sich, daß für Piezokeramiken mit Kopplungsfaktoren $k_p < 0,60$ Dielektrizitätszahlen im Bereich von 2000 bis 4000 erreichbar sind, was sich allerdings nur durch hohen Materialaufwand (ca. 10 Gew.-% teures $Nb_2O_5$) realisieren läßt. Zudem erfolgt die Synthese solcher Piezokeramiken bei vergleichsweise hohen Sintertemperaturen.

Aufgabe der Erfindung war es also, eine piezoelektrische Keramik bereitzustellen, die neben einer hohen Dielektrizitätszahl gleichzeitig auch einen hohen elektromechanischen Kopplungsfaktor besitzt und die sich wirtschaftlich herstellen läßt, das bedeutet, die unter Anwendung preisgünstiger Additive bei vergleichsweise niedrigen Sintertemperaturen erhältlich ist.

Gelöst wird diese Aufgabe durch piezoelektrisches Keramikmaterial der eingangs genannten Gattung, dessen Kennzeichenmerkmale darin zu sehen sind, daß piezoelektrisches Keramikmaterial als Additive komplexe Verbindungen mit der allgemeinen Formel

$$A(W^{6+}_{1/3} Ni^{3+}_{2/3})O_3$$

mit A = Pb, Sr, Ba oder Ca
als ternäre bzw. quaternäre feste Lösungen in einer Menge von 1 bis 10 Mol-% enthält, bezogen auf die Gesamtmenge an Keramikmaterial. Vorzugsweise ist das Additiv in einer Menge im Bereich von 2 bis 7 Mol-% enthalten.

Überraschend wurde gefunden, daß sich die erfindungsgemäßen Zusammensetzungen auszeichnen durch

$$Dielektizitätszahl \ \frac{\varepsilon^{T}_{33}}{\varepsilon_0} \geq 2000$$

$$\text{elektromechan. Kopplungsfaktor } k_p \geq 0{,}598$$

Vorzugsweise weist ein aus dem erfindungsgemäßen piezoelektrischen Keramikmaterial hergestelltes Formteil eine mechanische Güte $Q_m$ von $\leq 150$ bzw. eine hohe piezoelektrische Ladungskonstante $d_{33}$ von $\geq 500 \cdot 10^{-12}$ m/V auf.

Für die erfindungsgemäßen kostengünstigen Werkstoffe, die insbesondere mit geringerem $Nb_2O_5$-Anteil hergestellt werden können, ergeben sich vorzugsweise die folgenden besonders günstigen physikalischen Eigenschaften:

$$\frac{\varepsilon^{T}_{33}}{\varepsilon_0} \geq 4000 \ und \ k_p \geq 0{,}62$$

$$\text{Sintertemperatur } T_S \leq 1250 \ °C$$

Als Additive haben sich insbesondere bewährt:

$$(1\text{-}z) \ Pb(Ti_uZr_v) \ (Mg_{1/3}Nb_{2/3})_w \ O_3 - z \ A(W_{1/3}Ni_{2/3}) \ O_3,$$

Besonders wird $Ni^{3+}$ in der substituierten komplexen Verbindung wirksam. Mit Zusammensetzungen der genannten quaternären festen Lösungen können je nach Art und Konzentration der Additive piezoelektrische Keramiken bei Sintertemperaturen $T_S$ von $\leq 1150$ °C hergestellt werden, wobei gleichzeitig mindestens 25 % geringere Materialkosten anfallen.

Die erfindungsgemäßen piezoelektrischen Keramiken werden vorzugsweise für Schall- und Ultraschallwandler in der Akustik und Hydroakustik sowie für Aktuatoren verwendet.

Die nachfolgenden Ausführungsbeispiele sollen die Erfindung noch anschaulicher machen, die jedoch nicht auf die konkret dargestellten Ausführungsformen beschränkt sein soll.

Im Rahmen der Beispiele wurden quaternäre feste Lösungen folgender Zusammensetzung hergestellt:

$$(1\text{-}z) \ Pb(Ti_uZr_v) \ (Mg_{1/3}Nb_{2/3})_wO_3 - z \ A(W_{1/3}Ni_{2/3})O_3,$$

worin gelten soll, daß

$$u + v + w = 1 \qquad u = x - 1/3w$$

$$w = 0{,}045 \ ... \ 0{,}45 \qquad v = y - 2/3w$$

$$z = 0{,}01 \ ... \ 0{,}10 \qquad x + y = 1$$

$$\text{mit } x = 0{,}40 \ ... \ 0{,}60$$

Beispiel 1

Es wurde folgende Verbindung hergestellt:

$$0{,}97 \ Pb(Ti_{0,385}Zr_{0,24}) \ (Mg_{1/3}Nb_{2/3})_{0,375}O_3 - 0{,}03 \ Pb \ (W_{1/3}Ni_{2/3})O_3$$

Dazu wurden die Rohstoffe als Metalloxide beziehungsweise -carbonate entsprechend der stöchiometrischen Zusammensetzung eingewogen und in einem wässrigen Medium in einer Kugelmühle über einen Zeitraum von 10 h gemischt und gemahlen. Anschließend wurde die Mischung getrocknet, bei einer Temperatur von 850 °C kalziniert, feingemahlen, in einem Sprühtrockner granuliert und dann unter einem Druck von 100 MPa zu scheibenförmigen Prüfkörpern verpreßt. Die Prüfkörper wurden danach bei der nachfolgend angegebenen Temperatur bei einer Haltezeit von 1 h dichtgesintert, was zu runden Scheiben mit einem Durchmesser von 10 mm und einer Dicke von 1 mm führte.

An den so hergestellten Prüfkörpern wurden nach Metallisierung durch Einbrennen einer Silbersiebdruckpaste und Polung mit einer Spannung von 2,5 kV über eine Zeit von 5 min bei einer Temperatur von 100 °C die Dielektrizitätszahl bei einer Frequenz von 1 kHz und bei 0,5 V, der elektromechanische Kopplungsfaktor, die mechanische Güte und die

EP 0 619 279 B1

piezoelektrischen Koeffizienten ermittelt. Dazu wurden folgende Meßgeräte benutzt:

-- Impedanz Analyser HP 4194 A für die Messung der Kapazität (Dielektrizitätszahl) und der elektromechanischen Kenngrößen $k_p$ und $Q_m$ nach dem Resonator-Meßverfahren im Einklang mit DIN IEC 483,

-- ein Berlincourt-Meter (quasistatisches Meßverfahren) zur Bestimmung der piezoelektrischen Koeffizienten $d_{33}$ und $g_{33}$ gemäß DIN IEC 483.

Für die Prüfkörper nach Beispiel 1 ergaben sich folgende Meßwerte:

$$Dielektrizitätszahl \ \frac{\varepsilon^T_{33}}{\varepsilon_0} = 4115$$

elektromechanischer Kopplungsfaktor $k_p = 0{,}64$
Sintertemperatur $T_S = 1.250 \ °C$
piezoelektrische Ladungskonstante $d_{33} = 720 \cdot 10^{-12} \ m/V$
piezoelektrischer Spannungskoeffizient $g_{33} = 19{,}8 \cdot 10^{-3} \ Vm/N$
mechanische Güte $Q_m = 85$

Beispiel 2

Nach der Arbeitsvorschrift gemäß Beispiel 1 wurden, Prüfkörper mit einem Durchmesser von 10 mm und einer Dicke von 1 mm aus folgender Verbindung hergestellt:

$$0{,}94 \ Pb(Ti_{0{,}415}Zr_{0{,}46}) \ (Mg_{1/3}Nb_{2/3})_{0{,}125}O_3 - 0{,}06 \ Sr(W_{1/3}Ni_{2/3})O_3.$$

An den Prüfkörpern nach Beispiel 2 wurden genauso wie in Beispiel 1 die folgenden physikalischen Eigenschaften gemessen:

$$Dielektizitätszahl \ \frac{\varepsilon^T}{\varepsilon_0} = 2445$$

$k_p = 0{,}598$
$T_S = 1150 \ °C$
$d_{33} = 530 \cdot 10^{-12} \ m/V$
$g_{33} = 24{,}3 \cdot 10^{-3} \ Vm/N$
$Q_m = 130$

**Patentansprüche**

1. Piezoelektrisches Keramikmaterial auf Basis von Bleititanatzirkonat und weiteren Additiven, dadurch gekennzeichnet, daß es als Additive komplexe Verbindungen mit der allgemeinen Formel

$$A(W^{6+}_{1/3} \ Ni^{3+}_{2/3})O_3$$

mit A = Pb, Sr, Ba oder Ca
als ternäre bzw. quaternäre feste Lösungen in einer Menge von 1 bis 10 Mol-% enthält, bezogen auf die Gesamtmenge an Keramikmaterial.

2. Piezoelektrisches Keramikmaterial nach Anspruch 1, dadurch gekennzeichnet, daß in der allgemeinen Formel des komplexen Additivs für A Pb oder Sr steht.

3. Piezoelektrisches Keramikmaterial nach Anspruch 1 oder 2, dadurch gekennzeichnet, daß es das komplexe Additiv in einer Menge im Bereich von 2 bis 7 Mol-% enthält.

4. Gesintertes piezoelektrisches Formteil aus einem Material nach einem der Ansprüche 1 bis 3, dadurch gekennzeichnet, daß es eine

$$\textit{Dielektizitätszahl} \; \frac{\varepsilon^T_{33}}{\varepsilon_0} \geq 2000$$

und einen elektromechan. Kopplungsfaktor $k_p \geq 0{,}598$ besitzt.

5. Formteil nach Anspruch 4, dadurch gekennzeichnet, daß es eine

$$\textit{Dielektrizitätszahl} \; \frac{\varepsilon^T_{33}}{\varepsilon_0} \geq 4000$$

und einen elektromechan. Kopplungsfaktor $k_p \geq 0{,}62$ besitzt und daß es bei einer Sintertemperatur $T_S \leq 1250 \; °C$ gesintert ist.

6. Formteil nach Anspruch 4 oder 5, dadurch gekennzeichnet, daß es eine niedrige mechanische Güte $Q_m$ von $\leq 150$ besitzt.

7. Formteil nach einem der Ansprüche 4 bis 6, dadurch gekennzeichnet, daß es eine hohe piezoelektrische Ladungs-konstante $d_{33}$ von $\geq 500 \cdot 10^{-12}$ m/V aufweist.

8. Verwendung von piezoelektrischer Keramik nach einem der Ansprüche 4 bis 7 zum Einsatz in Schall- oder Ultraschallwandlern für die Akustik oder Hydroakustik.

9. Verwendung von piezoelektrischer Keramik nach einem der Ansprüche 4 bis 7 zum Einsatz in Aktuatoren.

**Claims**

1. A piezoelectric ceramic material based on lead zirconate titanate and further additives, which contains as additives complex compounds having the formula

$$A(W^{6+}_{1/3} Ni^{3+}_{2/3})O_3$$

with A = Pb, Sr, Ba or Ca
as ternary or quaternary solid solutions in an amount from 1 to 10 mol%, based on the total amount of ceramic material.

2. A piezoelectric ceramic material as claimed in claim 1, wherein A in the formula of the complex additive is Pb or Sr.

3. A piezoelectric ceramic material as claimed in claim 1 or 2, which contains the complex additive in an amount in the range from 2 to 7 mol%.

4. A sintered piezoelectric shaped part of a material as claimed in any one of claims 1 to 3, which possesses a

$$\textit{dielectric constant} \; \frac{\varepsilon^T_{33}}{\varepsilon_0} \geq 2000$$

and an electromechanical coupling coefficient $k_p \geq 0.598$.

5. A shaped part as claimed in claim 4, which possesses a

$$\textit{dielectric constant} \; \frac{\varepsilon^T_{33}}{\varepsilon_0} \geq 4000$$

and an electromechanical coupling coefficient $k_p \geq 0.62$ and is sintered at a sintering temperature $T_S \leq 1250°C$.

6. A shaped part as claimed in claim 4 or 5, which possesses a low mechanical quality factor $Q_m$ of $\leq 150$.

**7.** A shaped part as claimed in any one of claims 4 to 6, which has a high piezoelectric strain-field coefficient $d_{33}$ of $\geq$ $500 \cdot 10^{-12}$ m/V.

**8.** Use of a piezoelectric ceramic as claimed in any one of claims 4 to 7 for installation in sound or ultrasound transducers for acoustics or underwater sound applications.

**9.** Use of a piezoelectric ceramic as claimed in any one of claims 4 to 7 for installation in actuators.

**Revendications**

**1.** Matériau céramique piézoélectrique à base de titanate-zirconate de plomb et d'autres additifs, caractérisé en ce qu'il contient en tant que matières d'addition des composés complexes de formule générale

$$A(W^{6+}_{1/3} Ni^{3+}_{2/3})O_3$$

avec A = Pb, Sr, Ba ou Ca
en tant que solutions solides ternaires ou quaternaires, à raison de 1 à 10 % en moles, par rapport à la quantité totale du matériau céramique.

**2.** Matériau céramique piézoélectrique selon la revendication 1, caractérisé en ce que dans la formule générale de l'additif complexe A représente Pb ou Sr.

**3.** Matériau céramique piézoélectrique selon la revendication 1 ou 2, caractérisé en ce qu'il contient la matière d'addition complexe à raison de 2 à 7 % en moles.

**4.** Corps moulé piézoélectrique fritté d'un matériau selon l'une des revendications 1 à 3, caractérisé en ce qu'il a une

$$\text{constante de diélectricité } \frac{\varepsilon^{T}_{33}}{\varepsilon_0} \geq 2000$$

et un coefficient de couplage électromécanique $k_p \geq 0,598$.

**5.** Corps moulé selon la revendication 4, caractérisé en ce qu'il a une

$$\text{constante de diélectricité } \frac{\varepsilon^{T}_{33}}{\varepsilon_0} \geq 4000$$

et un coefficient de couplage électromécanique $k_p \geq 0,62$ et en ce qu'il est fritté à une température de frittage $T_S$ $\leq 1250$ °C.

**6.** Corps moulé selon la revendication 4 ou 5, caractérisé en ce qu'il a une faible qualité mécanique $Q_m$ de $\leq 150$.

**7.** Corps moulé selon l'une des revendications 4 à 6, caractérisé en ce qu'il présente une constante de charge piézoélectrique $d_{33}$ de $\geq 500.10^{-12}$ m/V.

**8.** Utilisation d'une céramique piézoélectrique selon l'une des revendications 4 à 7 pour des applications dans des transformateurs acoustiques ou à ultrasons dans l'acoustique ou l'hydroacoustique.

**9.** Utilisation d'une céramique piézoélectrique selon l'une des revendications 4 à 7 pour des applications dans des actuateurs.